# EUROPEAN PATENT SPECIFICATION

(11) **EP 0 491 403 B1**
(45) Date of publication and mention of the grant of the patent: **05.03.1997**
(21) Application number: 91121862.6
(22) Date of filing: 19.12.1991
(51) Int. Cl.: G01R 23/12

(54) **Device for estimating the carrier frequency of a digital signal**
Vorrichtung zur Abschätzung der Trägerfrequenz eines digitalen Signals
Dispositif pour estimer la fréquence porteuse d'un signal digital

(30) Priority: 19.12.1990 IT 2244490
(43) Date of publication of application: 24.06.1992
(73) Proprietor: ALCATEL ITALIA S.p.A., 20158 Milano (IT)
(72) Inventor: Guglielmi, Franco, I-20100 Milano (IT); Spalvieri, Arnaldo, I-60019 Senigallia (IT)
(74) Representative: Strehl Schübel-Hopf Groening & Partner

(56) References cited:
- EP-A- 0 289 289
- EP-A- 0 373 802
- EP-A- 0 373 802
- DE-A- 3 736 124
- FR-A- 2 552 959
- US-A- 4 611 165
- US-A- 4 904 930
- US-A- 4 904 930

## Description

The present invention relates to a device for estimating the carrier frequency of a digital signal, in particular a QAM or PSK modulated signal.

At present, in digital transmission systems, various estimators for the carrier frequency are used. Said estimators have the common feature of correctly operating only when the power spectral density associated with signaling has even symmetry with respect to the carrier frequency. Such feature is due to the fact that all known estimators make an estimate of the spectrum centroid. When the spectrum is non-symmetrical, its centroid does not coincide with the carrier frequency, and conventional systems make an uncorrect estimate therefore.

In radio link transmissions, unfavorable propagation phenomena, in particular the so-called "selective fading", cause dissymmetries in the spectrum, these making conventional estimators unusable.

The conventional technique used in radio links consists in generating an estimate of the carrier that changes periodically in the frequency intervall to which the signal carrier a priori is supposed to belong. When the estimated carrier frequency is equal to the signal carrier frequency, a suitable detector indicates correctness of the estimate and interrupts the periodic variation of the estimate.

Such technique presents the problem of realising such detector; moreover, in conventional systems, in order to obtain a satisfactory operation of said detector, it is necessary to keep low the rate in the estimate variation, thus slowing down the process of recognizing the signal carrier frequency.

EP-A-0 373 802 discloses a device for estimating a signal frequency in accordance with the first part of claim 1. There, instantaneous signal phase values are obtained at a succession of time intervals by a process known as "phase unwrapping", and the gradient of a straight line which would best pass through a plot of such values against time is determined as an estimate of the signal frequency.

A first object of the invention is to provide a device of estimating the carrier frequency which is unaffected by dissymmetries in the signal power spectral density.

Another object is to provide a circuitry that is simple and effective for implementing such a method.

According to the invention, at each signaling interval (time distance of two successive transmitted data), a phase estimate for said carrier and a comparison between two successive estimates are made. Said comparison, suitably filtered, provides a control signal to be fed to the circuit which generates the estimated carrier.

It has been found, inter alia, that unaffectedness against dissymmetries in the signal power spectral density is advantageous in radio link connections, since it involves a simplification of the circuitry and an increase in the rate of recognition of the signal carrier frequency.

The solution of the invention is based upon the estimate of phase ϕₖ in the kth signaling interval.

If 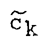 is the received complex signal at the kth signaling interval, it may be expressed by equation (I): 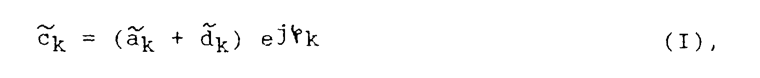 where ãₖ is the complex data transmitted at the kth signaling interval and 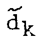 is the complex disturbance overlapped to the data and including noise, interference from other transmissions and intersymbolic interference.

If ãₖ is the complex data estimated by the receiver at 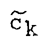 , an estimate of the term e^{jϕ} k, designated with 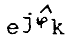 is obtainable through equation (II): 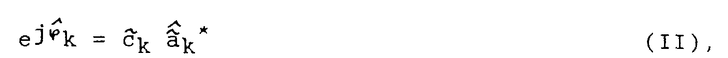 where ã̂ₖ* denotes the complex conjugate of the estimated data ã̂ₖ

According to the invention, the estimate 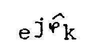 is stored whilst the phase estimator goes on in producing the estimate relative to the successive signaling intervals. After N signaling intervals, the estimate 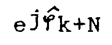 will also be available. Since the carrier frequency is defined as the derivative of the carrier phase with respect to time, an approximation of said frequency is obtainable by determining the difference between two phases extracted at successive times.

Operatively such difference is realized by multiplying the term relative to the (k+N)th interval with the complex conjugate of the term relative to the kth interval and taking only the imaginary part of the product as indicated in equation (III): 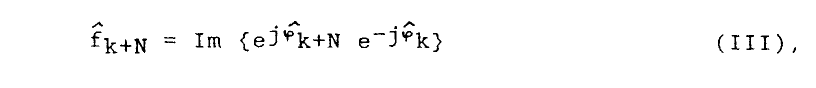 where f̂_{k+N} denotes the frequency estimate at the (k+N)th interval whilst Im denotes the imaginary part.

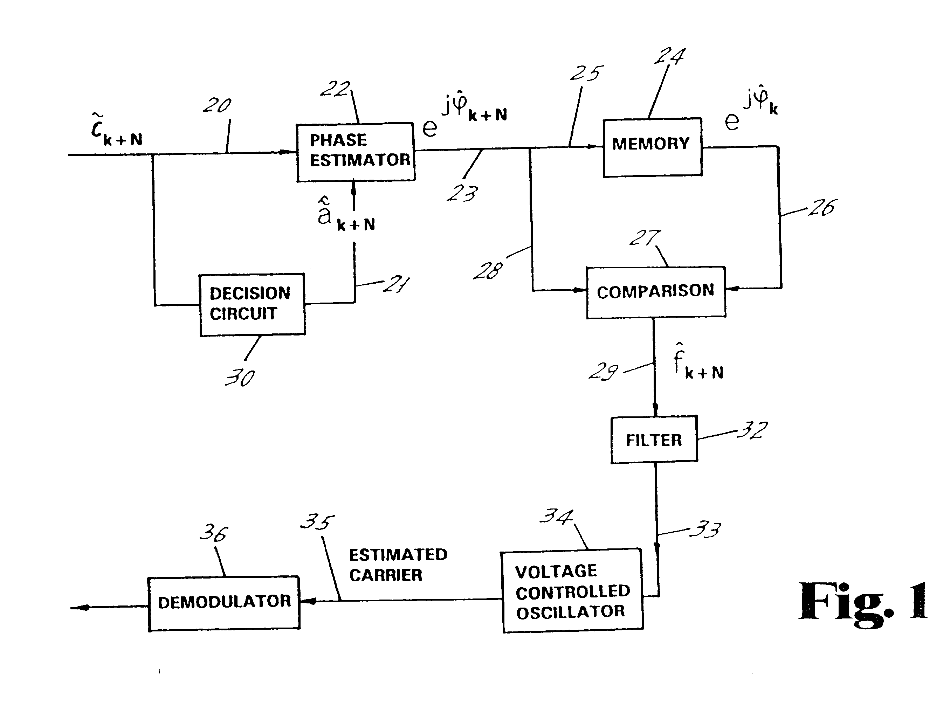

The process of the f̂_{k+N} estimate processing is synthetically illustrated in the schematic block diagramm of fig. 1. In said figure there are shown:
- a phase estimator device 22; at signaling instant k+N, said estimator 22 has at its inputs the received complex signal (line 20) and the complex data ã̂_{k+N} locally estimated e.g. in a decision circuit 30 of the receiver (line 21), and it provides the output signal 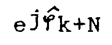 (line 23) by operating in accordance with equation II (referred to signaling instant k+N);
- a storage device 24 which receives the phase estimate 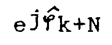 at its input (line 25), buffers the same, and provides at its output the estimate 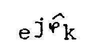 processed by phase estimator at the previous signaling instant k (line (26); and
- a comparison device 27 which receives at its input two estimates 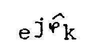 (line 26) and 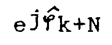 (line 28) and outputs the frequency estimate f̂_{k+N} (line 29) by operating in accordance with equation III.

The frequency estimate obtained according to the invention on line 29 is applied to conventional circuitry of the receiver comprising substantially a filter 32, a generator 34 (VCO) connected to said filter via a line 33 and generating the estimated carrier, and a demodulator 36 (DEM) receiving said estimated carrier signal via a line 35.

In a particularly advantageous embodiment of the invention, the device according to the invention comprises: four multipliers and two adders for carrying out the complex product generating process indicated by equation II; and a storage circuit, two multipliers and an adder for carrying out the operation indicated in equation III.

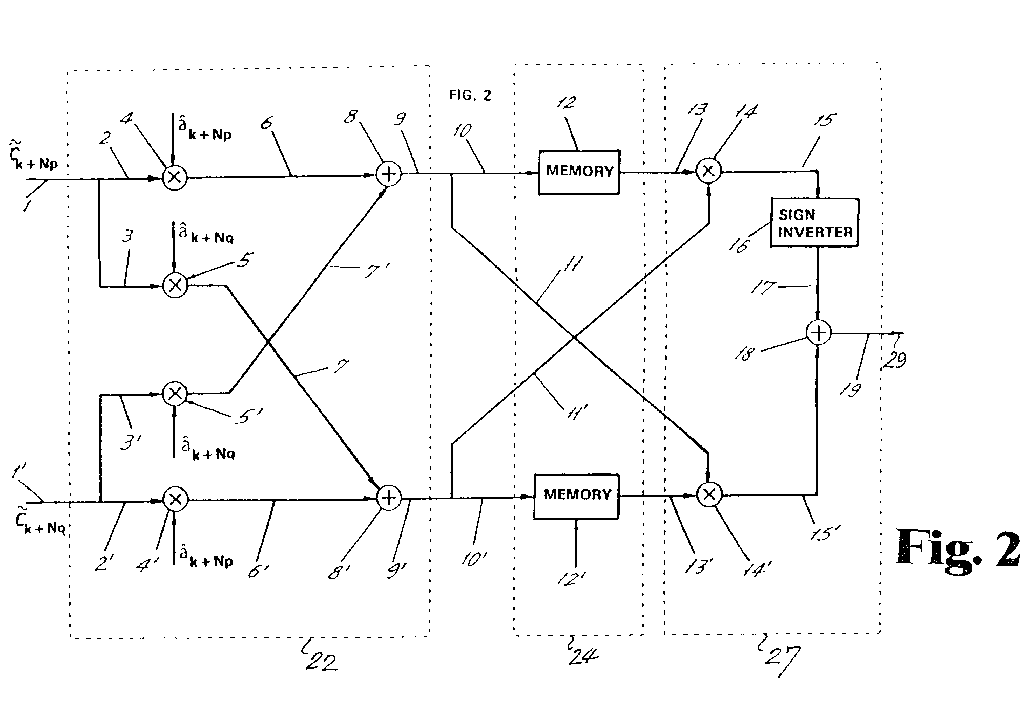

The various aspects an advantages of the invention will be more apparent from the description of an embodiment thereof illustrated as a not limitative example in the attached drawing (Fig. 2).

Signals c_{k+N,p} and c _{k+N,q} represent respectively the real (or in phase) part and the imaginary (or in quadrature) part of the complex signal 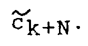

Blocks 4, 5, 14 and 4', 5', 14' marked with X represent multiplier circuits; blocks 8, 8', 18 marked with + represent adder circuits; blocks 12, 12' marked with memory represent memory banks designed to produce a delay of N signaling intervals; and block 16 marked with sign inverter represents a sign change.

As it can be seen in the figure, signals c_{k+N,p} and c_{k+N,q} go through analogous processes respectively marked by numerals with apostrophe and numerals without apostrophe.

Signal c_{k+N,p} is applied to line 1 and is then fed through lines 2 and 3 respectively to multipliers 4 and 5. Fed to the input of multiplier 4 is also the signal â_{k+N,p} which represents the real (or in phase) part of the complex signal ã̂_{k+N}. Fed to the input of multiplier 4 is also the signal â_{k+N,q} which represents the imaginary (or in quadrature) part of the complex signal ã̂_{k+N.}

Similarly, signal c_{k+N,q} is applied to line 1' and is then fed through lines 2' and 3' respectively to multipliers 4' and 5'. Fed to the input of multiplier 4' is also the signal â_{k+N,p} whilst signal â_{k+N,q} with its sign reversed is fed to the input of multiplier 5'.

The output signals of multipliers 5 and 4' are fed to the inputs of adder 8 through lines 6 and 7', respectively. The output signals of multipliers 5 and 4' are fed to the inputs of adder 8' through lines 7 and 6', respectively.

The output signal of adder 8 is applied via line 9 and then lines 10 and 11 simultaneously to delay blocks 12 (through line 10) and to multiplier 14' (through line 11). Similarly, the output signal of adder 8' is simultaneously fed via line 9' and then lines 10' and 11' to delay block 12' (through line 10') and to multiplier 14 (through line 11').

The outputs signals of delay blocks 12 and 12' are fed respectively to multipliers 14 and 14' through lines 13 and 13'. Through line 15, the output signal of multiplier 14 is fed to sign change block 16 whose output is fed to adder 8 through line 17. Through line 15', the output signal of multiplier 14' is fed to adder 18. The output signal of adder 18 is the frequency estimate f̂_{k+N} and is outputted through line 19.

All the elements of the circuit in Fig. 1 are realisable by using components available on the market, such as MOS, HCMOS logic, analog circuits, and so on. These realisations will suggest themselves to those of skill in this art.

## Claims

1. A device for estimating the carrier frequency of a digital signal in modulation transmission, particularly QAM or PSK transmission, including means for obtaining values of the instantaneous signal phase at subsequent instances and means for forming differences between the phase values thus obtained,
**characterised** in
that said means for obtaining signal phase values includes a first circuit (22) for estimating the signal phase at two instances k and (k+N) in accordance with the equations 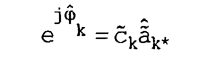 and 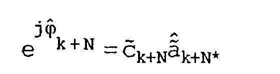 wherein
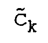 is the composite complex signal, comprising complex signal data and noise, at the k-th instant,
ã̂_{k*} is the complex conjugate of the signal data at the k-th instant,
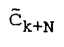 is the composite complex signal, comprising complex signal data and noise, at the (k+N)-th instant, and
ã̂_{k+N*} is the complex conjugate of the signal data at the (k+N)-th instant,
that a second circuit (24) is provided for storing the estimates of the signal phase obtained at the k-th instant, and
that said difference forming means includes a circuit (27) for calculating the difference between the phase estimate obtained at the (k+N)-th instant and the estimate stored in the second circuit (24) in accordance with the equation 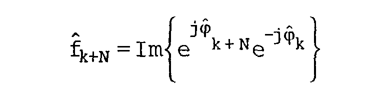 wherein
f̂_{k+N} is an estimate of the carrier frequency of the signal at the (k+N)-th instant and Im is the imaginary part of the product 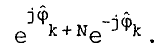

2. The device of claim 1, wherein said first circuit (22) includes
a first multiplier (4) for multiplying the real part of 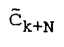 with the real part of ã̂_{k+N*} to generate a first product,
a second multiplier (5) for multiplying the real part of 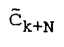 with the imaginary part of ã̂_{k+N*} to generate a second product,
a third multiplier (4') for multiplying the imaginary part of 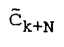 with the real part of ã̂_{k+N*} to generate a third product,
a fourth multiplier (5') for multiplying the imaginary part of 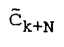 with the imaginary part of ã̂_{k+N*} to generate a fourth product,
a first adder (8) for adding the first and fourth products, and
a second adder (8') for adding the second and third products.

3. The device of claime 2, wherein the second circuit (24) includes a first memory (12) connected to the output of the first adder (8) and a second memory (12') connected to the output of the second adder (8').

4. The device of claim 3, wherein said circuit (27) for calculating the difference includes
a fifth multiplier (14) for multiplying the output of the first memory (12) with that of the second adder (8'),
a sixth multiplier (14') for multiplying the output of the second memory (12') with that of the first adder (8),
a sign inverter (16) for inverting the output of the fifth multiplier (14), and
a third adder (18) for adding the output of the sign inverter (16) and that of the sixth multiplier (14').

## Patentansprüche

1. Vorrichtung zum Abschätzen der Tägerfrequenz eine Digitalsignals bei Modulationsübertragung, insbesondere QAM- oder PSK-Übertragung, mit einer Einrichtung zur Gewinnung von momentanen Signalphasenwerten zu aufeinanderfolgenden Zeitpunkten und einer Einrichtung zur Bildung von Differenzen zwischen den so gewonnenen Phasenwerten,
dadurch **gekennzeichnet,**
daß die Einrichtung zur Gewinnung von momentanen Signalphasenwerten eine erste Schaltung (22) zum Abschätzen der Signalphase zu zwei Zeitpunkten k und (k+N) entsprechend den Gleichungen 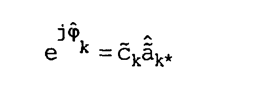 und 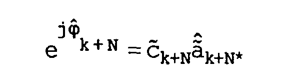 aufweist, wobei
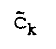 das komplexe Signaldaten und Rauschen enthaltende zusammengesetzte komplexe Signal zum Zeitpunkt k,
ã̂_{k*} das Konjugiert-Komplexe der Signaldaten zum Zeitpunkt k,
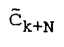 das komplexe Signaldaten und Rauschen enthaltende zusammengesetzte komplexe Signal zum Zeitpunkt (k+N), und
ã̂_{k+N*} das Konjugiert-Komplexe der Signaldaten zum Zeitpunkt (k+N) ist,
daß eine zweite Schaltung (24) zur Speicherung der zum Zeitpunkt k gewonnenen Schätzwerte der Signalphase vorgesehen ist, und
daß die differenzbildende Einrichtung eine Schaltung (27) zum Berechnen der Differenz zwischen dem zum Zeitpunkt (k+N) gewonnenen Schätzwert der Phase und dem in der zweiten Schaltung (24) gespeicherten Schätzwert entsprechend der Gleichung 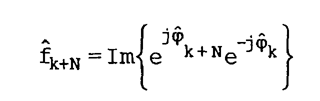 aufweist, wobei
f̂_{k+N} ein Schätzwert der Trägerfrequenz des Signals zum Zeitpunkt (k+N) und Im der Imaginarteil des Produkts 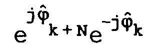 ist.

2. Vorrichtung nach Anspruch 1, wobei die erste Schaltung (22) aufweist:
eine erste Multiplizierstufe (4) zum Multiplizieren des Realteils von 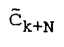 mit dem Realteil von ã̂_{k+N*} zur Bildung eines erstes Produkts,
eine zweite Multiplizierstufe (5) zum Multiplizieren des Realteils von 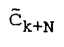 mit dem Imaginärteil von ã̂_{k+N*} zur Bildung eines zweiten Produkts,
eine dritte Multiplizierstufe (4') zum Multiplizieren des Imaginärteils von 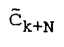 mit dem Realteil von ã̂_{k+N*} zur Bildung eines dritten Produkts,
eine vierte Multiplizierstufe (5') zum Multiplizieren des Imaginärteils von 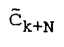 mit dem Imaginärteil von ã̂_{k+N*} zur Bildung eines vierten Produkts,
eine erste Addierstufe (8) zum Addieren des ersten und des vierten Produkts, und
eine zweite Addierstufe (8') zum Addieren des zweiten und des dritten Produkts.

3. Vorrichtung nach Anspruch 2, wobei die zweite Schaltung (24) einen an den Ausgang der ersten Addierstufe (8) angeschlossenen ersten Speicher (12) und einen an den Ausgang der zweiten Addierstufe (8') angeschlossenen zweiten Speicher (12') aufweist.

4. Vorrichtung nach Anspruch 3, wobei die differenzbildende Schaltung (27) aufweist:
eine fünfte Multiplizierstufe (14) zum Multiplizieren des Ausgangssignals des ersten Speichers (12) mit dem der zweiten Addierstufe (8'),
eine sechste Multiplizierstufe (14') zum Multiplizieren des Ausgangssignals des zweiten Speichers (12') mit dem der ersten Addierstufe (8),
einen Vorzeicheninverter (16) zum Invertieren des Ausgangssignals der fünften Multiplizierstufe (14), und
eine dritte Addierstufe (18) zum Addieren der Ausgangssignale des Vorzeicheninverters (16) und der sechsten Multiplizierstufe (14').

## Revendications

1. Dispositif pour estimer la fréquence porteuse d'un signal numérique en transmission par modulation, en particulier transmission par modulation d'amplitude en quadrature de phase ou par modulation par déplacement de phase, comportant des moyens pour obtenir des valeurs de la phase instantanée du signal à des instants qui se suivent et des moyens pour former les différences entre les valeurs de phase ainsi obtenues,
caractérisé en ce que
lesdits moyens pour obtenir des valeurs de phase de signal comportent un premier circuit (22) pour estimer la phase du signal à deux instants k et(k + N) conformément aux équations 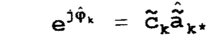 et 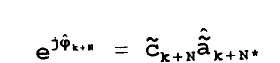 dans lesquelles
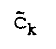 est le signal complexe composite, comportant des données de signal complexe et un bruit, au k-ième instant,
ã̂_{k*} est le conjugué complexe des données de signal au k-ième instant,
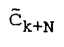 est le signal complexe composite, comportant des données de signal complexe et un bruit, au (k + N)-ième instant, et
ã̂_{k+N*} est le conjugué complexe des données de signal au (k + N)-ième instant,
en ce qu'un second circuit (24) est agencé pour mémoriser l'estimation de la phase de signal obtenue au k-ième instant, et
en ce que lesdits moyens de formation de différence comportent un circuit (27) pour calculer la différence entre l'estimation de phase obtenue au (k + N)-ième instant et l'estimation mémorisée dans le second circuit (24) conformément à l'équation 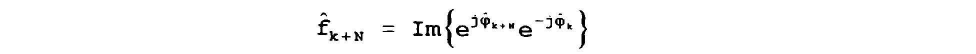 dans laquelle
f̂_{k+N} est une estimation de la fréquence porteuse du signal au (k + N)-ième instant et Im est la partie imaginaire du produit 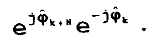

2. Dispositif selon la revendication 1, dans lequel ledit premier circuit (22) comporte
un premier multiplicateur (4) pour multiplier la partie réelle de 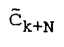 par la partie réelle de ã̂_{k+N*} pour engendrer un premier produit,
un deuxième multiplicateur (5) pour multiplier la partie réelle de 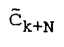 par la partie imaginaire de ã̂_{k+N*} pour engendrer un deuxième produit,
un troisième multiplicateur (4 ') pour multiplier la partie imaginaire de 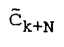 par la partie réelle de ã̂_{k+N*} pour engendrer un troisième produit,
un quatrième multiplicateur (5') pour multiplier la partie imaginaire de 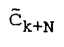 par la partie imaginaire de ã̂_{k+N*} pour engendrer un quatrième produit,
un premier additionneur (8) pour additionner le premier et le quatrième produit, et
un deuxième additionneur (8') pour additionner le deuxième et le troisième produit.

3. Dispositif selon la revendication 2, dans lequel le second circuit (24) comporte une première mémoire (12) reliée à la sortie du premier additionneur (8) et une seconde mémoire (12') reliée à la sortie du deuxième additionneur (8').

4. Dispositif selon la revendication 3, dans lequel ledit circuit (27) pour calculer la différence comporte
un cinquième multiplicateur (14) pour multiplier la sortie de la première mémoire (12) par celle du deuxième additionneur (8'),
un sixième multiplicateur (14') pour multiplier la sortie de la seconde mémoire (12') par celle du premier additionneur (8),
un inverseur de signe (16) pour inverser la sortie du cinquième multiplicateur (14), et
un troisième additionneur (18) pour additionner la sortie de l'inverseur de signe (16) et celle du sixième multiplicateur (14').
